## Europäisches Patentamt
## European Patent Office
## Office européen des brevets

(11) Veröffentlichungsnummer: **0 245 531**
**A1**

(12) **EUROPÄISCHE PATENTANMELDUNG**

(21) Anmeldenummer: **86106577.9**

(22) Anmeldetag: **14.05.86**

(51) Int. Cl.³: **G 11 C 7/00**
**G 10 H 7/00**

(43) Veröffentlichungstag der Anmeldung:
**19.11.87 Patentblatt 87/47**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(72) Erfinder: **Micic, Ljubomir, Dipl.-Ing.**
**Sundgauallee 15**
**D-7800 Freiburg i. Br.(DE)**

(72) Erfinder: **Fischer, Thomas, Dr. rer. nat.**
**In der Breite 44**
**D-7801 Umkirch(DE)**

(74) Vertreter: **Morstadt, Volker, Dipl.-Ing.**
**c/o Deutsche ITT Industries GmbH Patent/Lizenzabteilung**
**Postfach 840 Hans-Bunte-Strasse 19**
**D-7800 Freiburg/Brsg.(DE)**

(54) Verwendung von halbleitertechnischen Festwertspeichern.

(57) Zur Vermeidung der bei der üblichen Speicherung von Audiosignalen (ss) mittels Tonband, Schallplatte, Compact-Disc und Videorekorder erforderlichen mechanischen Bewegung zwischen Speichermedium und Abtastanordnung schlägt die Erfindung die Verwendung von halbleitertechnischen Festwertspeichern (ROMs) als Speicher (s) vor. Dabei können die digitalisierten Audiosignale (ss) redundanzbefreit abgespeichert werden. Dann ist in der Wiedergabeanordnung ein Datenexpander (xp) erforderlich, bevor die ausgelesenen Signale über einen Digital-Analog-Wandler (da) im üblichen analogen Audiokanal mit Analogverstärker (v) und Lautsprecheranordnung (sp) weiterverarbeitet werden. Auch ist eine Fehlerkorrekturstufe (ec) zwischen Speicher (s) und Expander (xp) einfügbar.

FIG.3

EP 0 245 531 A1

Fl 1291 EP
Mo/Be 0245531
13. Mai 1986

## Verwendung von halbleitertechnischen Festwertspeichern

Die digitale Speicherung von Audiosignalen, insbesondere Musiksignalen, geschieht nach dem neuesten Stand der Technik in Form der sogenannten Kompakt-Schallplatte (Compact-Disc), auf der die Audiosignale in pulscodemodulierter Form gespeichert sind. Auch die neuesten Videorekorder für 8-mm-Standard eignen sich für die Speicherung von pulscodemodulierten Audiosignalen. Beide Speichermedien erfordern zur Wiedergabe eine Bewegung zwischen dem Speichermedium und einem entsprechend ausgebildeten Abtastkopf. Diese neuesten Entwicklungen beruhen also nach wie vor von dem schon seit mehreren Jahrzehnten gebräuchlichen Prinzip der Verwendung eines bewegten Aufzeichnungsträgers. Die mit diesem Aufzeichnungsprinzip verbundenen Schwierigkeiten hat man zwar in langen Jahren zu beherrschen gelernt, sie sind jedoch immer noch lästig, und ein nicht auf Bewegung zwischen Aufzeichnungsmedium und Abtastkopf beruhendes Speicherverfahren für Audiosignale würde daher die ganze Wiedergabemechanik überflüssig machen.

Die Aufgabe der in den Ansprüchen gekennzeichneten Erfindung besteht daher darin, ein von dem eben geschilderten, bisher ausschließlich üblichen Speicher- und Wiedergabeprinzip abweichendes neues Prinzip anzugeben.

Durch die erfindungsgemäße Verwendung von halbleitertechnischen Festwertspeichern (ROMs) als Speichermedium für Audiosignale, insbesondere Musiksignale, läßt sich ein Wiedergabegerät ohne bei der Wiedergabe zu bewegende und bewegte Teile konzipieren, das allenfalls noch mechanische Bewegungen beim Einlegen und Entnehmen des Speichers erfordert.

L. Micic et al 26-6                                    Fl 1291 EP

Die Erfindung wird nun anhand der Figuren der Zeichnung
näher erläutert.

Fig. 1 zeigt das schematische Blockschaltbild einer
Wiedergabeanordnung für einen erfindungsgemäßen
Speicher,

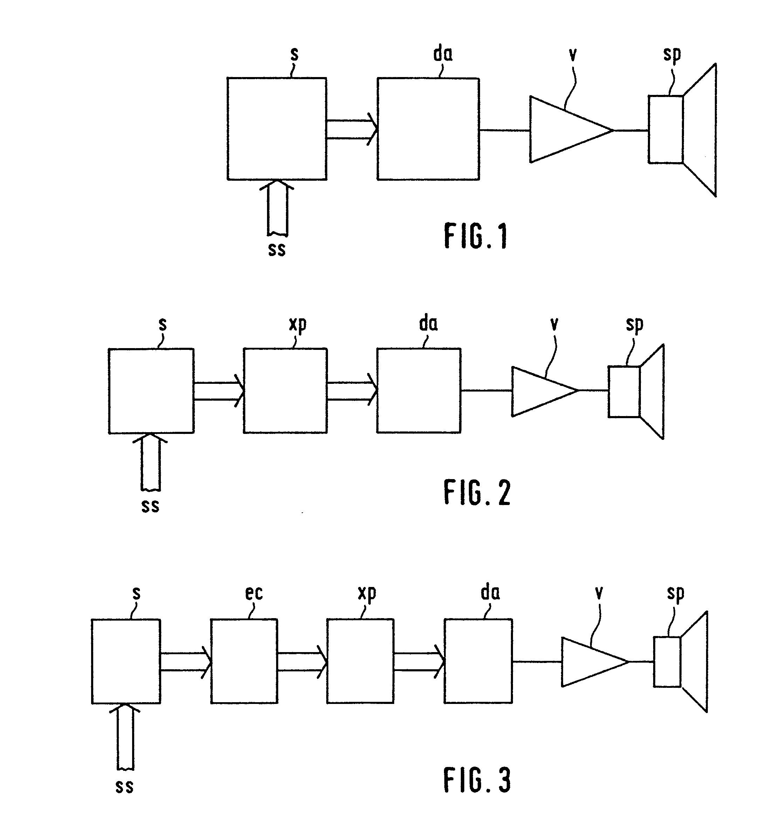

Fig. 2 zeigt das schematische Blockschaltbild einer
Weiterbildung der Wiedergabeanordnung nach
Fig. 1, und

Fig. 3 zeigt das schematische Blockschaltbild einer
Weiterbildung der Anordnung nach Fig. 2.

Im schematischen Blockschaltbild der Fig. 1 ist der Speicher
s gezeigt, der ein halbleitertechnischer Festwertspeicher
(ROM) üblicher Art ist. Je nach der erforderlichen Speicherkapazität kann für den Speicher s eine Anordnung aus mehreren einzelnen Halbleiterchips oder aber auch bevorzugt
ein einziger Halbleiterchip eingesetzt werden. Ihm werden
beim entgültigen Herstellungschritt der Programmierung
die digitalisierten Audiosignale ss eingespeichert.

Diese Signale sind nach einer bevorzugten Ausgestaltung
der Erfindung mindestens teilweise redundanzbefreit, so
daß eine möglichst optimale Ausnutzung der zur Verfügung
stehenden Speicherfläche erreicht wird. Für diese Redundanzbefreiung eignet sich beispielsweise die adaptive Differenz-Pulscodemodulation oder auch eine Transformationscodierung, was z.B. eine Fourier-Transformation mit Unterdrükkung derjenigen Spektrallinien bedeutet, die einen
unterhalb eines festgelegten Schwellwerts liegenden Energie
Inhalt haben.

Nach einer Ausgestaltung der Erfindung kann (können) der
(die) Halbleiterchip(s), die den Speicher s bilden, in einem
für die Wiedergabe handhabbar großen Träger oder Gehäuse
untergebracht werden, so daß sich ein Solid State Digital
Disc (= SSDD = $S^2D^2$) ergibt, dessen Größe z.B. vergleichbar

mit der erwähnten Compact Disc ist.

Im prinzipiellen Ausführungsbeispiel der Fig. 1 ist dem Ausgang des Speichers s der Digital-Analog-Wandler danachgeschaltet, dessen Ausgang wiederum der analoge Audioverstärker v mit zugehöriger Lautsprecheranordnung sp nachgeschaltet ist. Im allgemeinen wird diese Lautsprecheranordnung sp mindestens die für Stereowiedergabe erforderlichen Lautsprecher umfassen.

Die Fig. 2 zeigt das Schaltbild einer Ausführungsform einer Weiterbildung der Anordnung nach Fig. 1; diese besteht darin, daß zwischen dem Speicher s und dem Digital-Analog-Wandler da der Datenexpander xp angeordnet ist, der dann erforderlich ist, wenn die oben erläuterte Redundanzbefreiung der im Speicher s gespeicherten Audiosignale ss vorliegt. Zur Realisierung des Datenexpanders xp kann ein digitaler Signalprozessor dienen, der ebenfalls als Festkörperschaltung, insbesondere Microprozessor, ausgebildet ist. Durch die Verwendung derartiger digitaler Signalprozessoren als Datenexpander xp kann bei der Speicherung der Datenreduktions-Algorithmus an die Gegebenheiten unterschiedlicher Audiosignale optimal angepaßt werden. Dabei werden charakteristische Eigenschaften des speziellen Datenreduktions-Algorithmus im Speicher s ebenfalls abgelegt, die bei der Wiedergabe das spezielle Expander-Programm des digitalen Signalprozessors steuern. Da die Datenreduktion nur bei der Aufbereitung der abzuspeichernden Audiosignale ss erforderlich ist und dies nur in entsprechend ausgerüsteten Aufnahmestudios geschieht, kann der Datenreduktions-Algorithmus ausgezeichnet optimiert werden, so daß die bei der Wiedergabe erforderlichen Algorithmen sehr stark minimiert werden können.

Nach einer bevorzugten Ausgestaltung der Erfindung können die Audiosignale auch in einer Form abgespeichert sein, daß auf verschiedene Arten von Audiosignalen entsprechend angepaßte Datenreduktions-Algorithmen anwendbar sind. Im Speicher s ist dann den einzelnen Algorithmen eine Kennung
zugeordnet, die z.B. auf ein entsprechendes Signal hin
abrufbar ist und den Expander-Algorithmus das Datenexpanders
xp bestimmt. Auch kann dieser bevorzugt ein programmierbarer
digitaler Signalprozessor sein, dessen Programm im Speicher s ebenfalls abgelegt ist.

In Fig. 3 ist schließlich das Blockschaltbild einer Weiterbildung der Anordnung nach Fig. 2 gezeigt, bei der zwischen
dem Speicher s und dem Datenexpander xp die Fehlerkorrekturstufe ec vorgesehen ist. Der hierzu erforderliche
Fehlererkennungs- und -korrektur-Algorithmus kann dabei
ebenfalls bereits im Speicher s mit abgelegt sein.
Außerdem kann das Ausmaß der Fehlerkorrektur an den
erwähnten Datenreduktions-Algorithmus angepaßt werden.

Auch hier kann der bereits erwähnte programmierbare
Signalprozessor eingesetzt werden, dessen Fehlerkorrektur-Programm im Speicher s abgelegt ist.

Es wurde festgestellt, daß mit einer fünffachen Datenreduktion eine mit der Qualität der heute üblichen
Compact Disc vergleichbare Qualität erreichbar ist.
Dabei ist für eine Stunde Wiedergabedauer eine Speichergröße von etwa 1 GBit erforderlich. Beim gegenwärtigen
Stand der Halbleitertechnologie erfordert dies zwar
mehrere Chips, es wird jedoch auch schon an der Vereinigung dieser Chips auf einem einzigen Halbleiterwafer
gearbeitet.

L. Micic et al 26-6

F1 1291 EP
Mo/Be
13. Mai 1986

## Patentansprüche

1. Verwendung von mindestens einem halbleitertechnischen Festwertspeicher (ROM) als Speicher (s) für digitalisierte Audiosignale (ss), insbesondere Musiksignale.

2. Speicher nach Anspruch 1, dadurch gekennzeichnet, daß er in einem einzigen Halbleiterchip realisiert ist.

3. Speicher nach Anspruch 1 oder 2, dadurch gekennzeichnet, daß der bzw. die Halbleiterchip (s) mit einem für die Wiedergabe handhabbar großen Träger oder Gehäuse zu einem Solid State Digital Disc ($= SSDD = S^2D^2$) vereinigt ist.

4. Speicher nach einem der Ansprüche 1 bis 3, dadurch gekennzeichnet, daß die digitalisierten Audiosignale (ss) in mindestens teilweise redundanzbefreiter Form abgespeichert sind.

5. Speicher nach Anspruch 4, dadurch gekennzeichnet, daß die abgespeicherten Audiosignale durch adaptive Differenz-Pulscodemodulation oder durch Transformationscodierung redundanzbefreit sind.

6. Wiedergabeschaltung für Speicher nach Anspruch 1, dadurch gekennzeichnet, daß ihm ein Digital-Analog-Wandler (da) und diesem ein analoger Audioverstärker (v) mit Lautsprecheranordnung (sp) nachgeschaltet ist.

7. Wiedergabeschaltung nach Anspruch 6 für Speicher nach Anspruch 4 oder 5, dadurch gekennzeichnet, daß zwischen Speicher (s) und Digital-Analog-Wandler (da) ein die Redundanzbefreiung aufhebender Datenexpander (xp) angeordnet ist.

8. Wiedergabeschaltung nach Anspruch 7, dadurch gekennzeichnet, daß zwischen Speicher (s) und Datenexpander (xp) eine Fehlerkorrekturstufe (ec) angeordnet ist.

9. Speicher nach Anspruch 4 oder 5, dadurch gekennzeichnet, daß charakteristische Eigenschaften mindestens eines Datenreduktions-Algorithmus abgespeichert sind.

10.Wiedergabeschaltung nach Anspruch 7 oder 8 für einen Speicher nach Anspruch 9, dadurch gekennzeichnet, daß der Datenexpander (xp) und/oder die Fehlerkorrekturstufe (ec) als programmierbarer Signalprozessor ausgebildet ist/sind und daß dessen/deren Steuerprogramm(e) im Speicher (s) abgelegt sind.

FIG.1

FIG.2

FIG.3

### Europäisches Patentamt

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | WO-A-8 301 705 (KRAMER et al.)<br>* Seite 1, Zeilen 1-13; Seite 2, Zeile 20 - Seite 3, Zeile 15; Seite 5, Zeilen 2-14; Seite 7, Zeile 23 - Seite 8, Zeile 12; Seite 10, Zeilen 6-16; Figuren 1,2 * | 1-10 | G 11 C 7/00<br>G 10 H 7/00 |
| | --- | | |
| Y | US-A-4 318 188 (SIEMENS)<br>* Spalte 1, Zeile 40 - Spalte 2, Zeile 2; Spalte 2, Zeilen 38-58; Spalte 3, Zeile 41 - Spalte 4, Zeile 2; Spalte 10, Zeilen 20-26; Figur 1 * | 1,2,6 | |
| | --- | | |
| Y | BELL SYSTEM TECHNICAL JOURNAL, Band 61, Nr. 8, Oktober 1982, Seiten 1841-1862, American Telephone and Telegraph Co., Murray Hill, New Jersey, US; J.E. ROWLEY et al.: "Using magnetic bubble memories to provide recorded announcements"<br>* Seite 1858, Zeile 4 - Seite 1859, Zeile 4; Figur 11 * | 8,10 | RECHERCHIERTE SACHGEBIETE (Int Cl.4)<br><br>G 11 C 7/00<br>G 10 H 7/00 |
| | --- | | |
| Y | DE-C-3 440 596 (DR. RAINER BÖHM GmbH)<br>* Spalte 3, Zeile 61 - Spalte 4, Zeile 9; Figur 1 * | 10 | |
| | ---       -/- | | |

Der vorliegende Recherchenbericht wurde für alle Patentansprüche erstellt.

| Recherchenort | Abschlußdatum der Recherche | Prüfer |
|---|---|---|
| DEN HAAG | 20-11-1986 | DAVIES H. |

# EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | FERNSEH- UND KINO TECHNIK, Band 39, Nr. 8, August 1985, Seiten 395-397; H. ZANDER: "Grundlagen und Verfahren der digitalen Audio-Technik" <br> * Seite 396, linke Spalte, Zeilen 21-38; Figur 9.3. * <br><br> ----- | 3,8,10 | |
| | | | **RECHERCHIERTE SACHGEBIETE (Int Cl 4)** |

Der vorliegende Recherchenbericht wurde für alle Patentansprüche erstellt.

| Recherchenort | Abschlußdatum der Recherche | Prüfer |
|---|---|---|
| DEN HAAG | 20-11-1986 | DAVIES H. |